# EUROPEAN PATENT APPLICATION

(11) **EP 2 835 907 A1**
(43) Date of publication of application: **11.02.2015**
(21) Application number: 14150164.3
(22) Date of filing: 03.01.2014
(51) Int. Cl.: H02S 40/34

(54) **Junction box and photovoltaic module comprising the same**

(30) Priority: 05.08.2013 US 201361862392 P
(71) Applicant: Samsung SDI Co., Ltd., Yongin-si, Gyeonggi-do (KR)
(72) Inventor: Ji, Yang-Geun, Gyeonggi-do (KR)
(74) Representative: Mounteney, Simon James

(57) **Abstract**

A junction box for connection to a photovoltaic module comprises a housing (100) and a conductive connection member (200) formed from a resilient conductive material and having first and second end portions (202e1, 202e2). The conductive connection member is moveable between a first position disposed at least partially outside the housing and a second position disposed substantially entirely within the housing. One of the conductive connection member or the housing comprises a first groove and the other of the conductive connection member or the housing comprises a first projection (121), wherein the first groove comprises an inclined surface such that as the conductive connection member moves between the first position and the second position the first projection moves in the first groove and the conductive connection member is compressed such that at least one of the first and second end portions is moved towards the other.

## Description

### BACKGROUND OF THE INVENTION

### Field of the invention

One or more embodiments of the present invention relate to a junction box and a photovoltaic module comprising the same.

### Description of Related Art

Solar cells directly convert light energy into electric energy by using a photovoltaic effect and attract attention as next generation cells. Solar cells are classified as silicon solar cells, thin film solar cells, dye sensitized solar cells, and organic polymer solar cells according to their forming materials.

Meanwhile, photovoltaic modules are referred to as solar cells connected in serial or parallel to each other. Photovoltaic modules may include a junction box collecting electricity generated by solar cells and preventing a current from flowing backward. In general, the junction box may include a diode for preventing the current from flowing backward and may be attached one side surface of a photovoltaic module.

### SUMMARY OF THE INVENTION

The present invention provided a junction box comprising:
a housing;
a conductive connection member formed from a resilient conductive material and having first and second end portions;
wherein the conductive connection member is moveable between a first position disposed at least partially outside the housing and a second position disposed substantially entirely within the housing;
wherein one of the conductive connection member or the housing comprises a first groove and the other of the conductive connection member or the housing comprises a first projection, wherein the first groove comprises an inclined surface such that as the conductive connection member moves between the first position and the second position the first projection moves in the first groove and the conductive connection member is compressed such that at least one of the first and second end portions is moved towards the other.

Preferably, in the first position, the first and second end portions are spaced apart from each other. Preferably, in the second position, the first and second end portions overlap. The housing may comprise a pressure projection which is configured to contact an overlapping portion of one of the first and second end portions in the second position, and one of the first and second end portions may include an adhesive material, preferably a conductive adhesive material, on a portion which is overlapped in the second position.

Preferably, the first groove comprises a first guide groove including the inclined surface and a first coupling groove in which the first projection engages in the second position.

Preferably, the housing comprises an extension portion projecting from the housing and comprising an attachment surface which is in the same plane as a bottom surface of the conductive connection member in the second position. An adhesive material may be provided on the attachment surface.

Preferably, one of the conductive connection member or the housing comprises a second groove and the other of the conductive connection member or the housing comprises a second projection which moves in the second groove as the conductive connection member moves between the first position and the second position. The second groove may comprises a second guide groove having a surface parallel to the direction of movement of the conductive connection member and a second coupling groove in which the second projection engages in the second position. The first groove and the first end portion may be disposed on a first side of the conductive connection member, and the second groove and the second end portion may be disposed on a second side of the conductive connection member opposite the first side wherein, as the conductive connection member moves between the first position and the second position, the first end portion moves towards the second end portion but the second end portion does not move towards the first end portion.

Preferably, the conductive connection member comprises an angle maintaining member configured to maintain an angle of the second end portion with respect to the direction of movement of the conductive connection member.

Preferably, the junction box further comprises a lead plate formed from a conductive resilient material and configured to connect the conductive connection member to a cable, the lead plate comprising a connection portion connected to a top portion of the conductive connection member.

Preferably, the first groove or the first and second grooves are formed in the conductive connection member, and the first projection or the first and second projections are on the housing.

The present invention further provides a photovoltaic module including a plurality of photovoltaic cells on a front surface of a substrate; at least one conductor connected to the photovoltaic cells and passing through the substrate and projecting from a rear surface of the substrate; and a junction box as defined above, wherein the conductor is gripped between the first and second end portions in the second position.

The present invention further provided a method of attaching a junction box to a conductor projecting from a surface comprising:
providing a junction box comprising:
   a housing;
   a conductive connection member positioned partially inside the housing and formed from a resilient conductive material and having first and second end portions spaced apart from each other;
positioning the junction box with the conductor between the first and second end portions;
moving the housing such that the conductive connection member moves entirely inside the housing and the housing contacts the surface;
wherein one of the conductive connection member or the housing comprises a first groove and the other of the conductive connection member or the housing comprises a first projection, wherein the first groove comprises an inclined surface such that as the conductive connection member moves into the housing the first projection moves in the first groove and the conductive connection member is compressed such that at least one of the first and second end portions is moved towards the other to grip the conductor.

Preferably, when the conductive connection member is entirely within the housing, the first and second end portions overlap, and the flexible conductor is gripped between the overlapping portions.

### BRIEF DESCRIPTION OF THE DRAWINGS

FIG. 1 is a schematic exploded perspective view of a photovoltaic module according to an embodiment of the present invention.
FIG. 2A is an exploded perspective view of a photovoltaic module before a junction box is attached thereto.
FIG. 2B is an exploded perspective view of a photovoltaic module after a junction box is attached thereto.
FIG. 3 is a bottom perspective view of a junction box according to an embodiment of the present invention.
FIG. 4 is a bottom perspective view of a housing of a junction box.
FIG. 5 is a top perspective view of conductive connection members of a junction box.
FIG. 6 is a bottom view of the junction box of FIG. 3.
FIG. 7A is a lateral cross-sectional view of a junction box before attached to second substrate.
FIG. 7B is a lateral cross-sectional view of a junction box after attached to second substrate.

### DETAILED DESCRIPTION OF THE INVENTION

The present invention can apply various transformations and can have various embodiments, so specific embodiments are illustrated in the drawings, and are explained in detail in the detailed description. However, it is not intended to limit the present invention to certain embodiments, but it should be understood to include all changes, equivalents and substitutes within the scope of the claims. The terms of 1st, 2nd, etc., are used to describe various components, but components should not be limited by the terms. The terms are only used to distinguish one component from the other components. The terminology used in the present invention has been used for describing particular embodiments only, and are not intended to limit the present invention. Singular expression includes the expression of the plural, unless the context clearly indicates otherwise. In the present application, the term of "including" or "having" must be understood not to preclude one or more other features, numbers, steps, operations, elements, or components, which are described in the specification, or existence of a combination of these things or the additional possibility, but to specify the presence of such features, numbers, steps, operations, elements, components, or any combination of them. On the other hand, to use of "/" may be interpreted as "and" and may be interpreted as "or" on a case-by-case basis.

In the drawings, the dimensions of layers and regions may be exaggerated for clarity. Like reference numerals refer to the like elements throughout. It will also be understood that when a layer, film, region, or substrate is referred to as being "on" another layer, film, region, or substrate, it can be directly on the other layer, film, region, or substrate, or intervening layers may also be present.

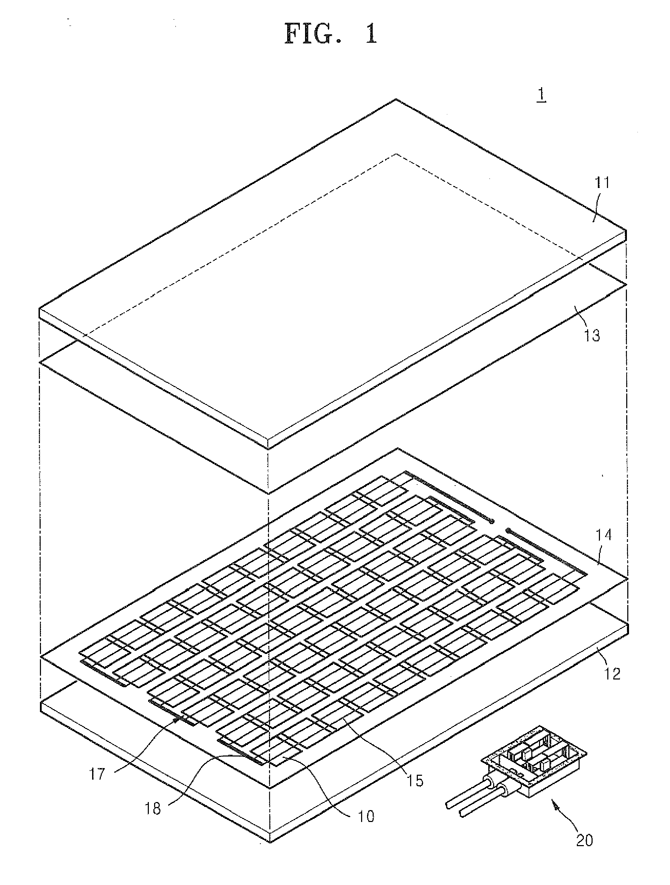

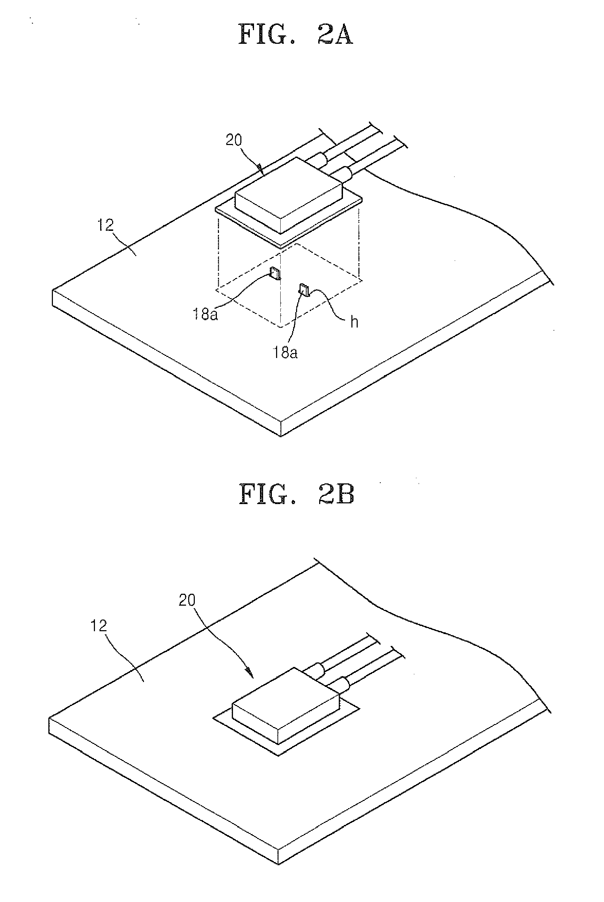

FIG. 1 is a schematic exploded perspective view of a photovoltaic module 1 according to an embodiment of the present invention. FIG. 2A is an exploded perspective view of the photovoltaic module 1 before a junction box 20 is attached thereto. FIG. 2B is an exploded perspective view of the photovoltaic module 1 after the junction box 20 is attached thereto. For convenience of explanation, FIGS. 2A and 2B show a second substrate 12 of the photovoltaic module 1 facing upward.

Referring to FIG. 1, the photovoltaic module 1 according to an embodiment of the present invention includes a plurality of solar cells 10, ribbons 15 configured to electrically connect the plurality of solar cells 10 to constitute a solar cell string 17, a first sealing film 13 and a first substrate 11 disposed on the solar cell string 17, a second sealing film 14 and a second substrate 12 disposed below the solar cell string 17, and the junction box 20 attached to the second substrate 12.

The solar cells 10, which are semiconductor devices converting solar energy into electric energy may be, for example, silicon solar cells including a first conductive type silicon substrate, a second conductive type semiconductor layer formed on the first conductive silicon substrate and having an opposite conductive type to the first conductive silicon substrate, an anti-reflective layer including at least one opening exposing a partial surface of the second conductive type semiconductor layer and formed on the second conductive type semiconductor layer, a front surface electrode contacting the partial surface of the second conductive type semiconductor layer exposed through the at least one opening, and a rear surface electrode formed on a rear surface of the first conductive type silicon substrate. However, the present invention is not limited thereto. The solar cells 10 may be compound semiconductor solar cells, tandem solar cells, and the like.

The first substrate 11 is a light receiving surface substrate and is formed of glass having excellent light transparency or a polymer material. The first substrate 11 has a sufficient rigidity so as to protect the solar cells 10 from an external shock, etc. For example, the first substrate 11 may be formed of tempered glass. The first substrate 11 may also be formed of low iron tempered glass to prevent reflection of solar light and increase transparency of the solar light.

The second substrate 12 is disposed to face the first substrate 11 and have waterproof, insulation, and ultraviolet (UV) rays blocking functions so as to protect the solar cells 10. The second substrate 12 may be formed by stacking polyvinyl fluoride/PET/polyvinyl fluoride layers but is not limited thereto.

The first sealing film 13 is disposed between the solar cells 10 and the first substrate 11. The second sealing film 14 is disposed between the solar cells 10 and the second substrate 12. The first and second sealing films 13 and 14 are bonded by lamination to prevent moisture or oxygen from penetrating into the solar cells 10. The first and second sealing films 13 and 14 may use ethylene-vinyl acetate (EVA) copolymer resin, polyvinyl butyral, an ethylene-vinyl acetate partial oxide, a silicon resin, an ester-based resin, an olefin-based resin, and the like.

The ribbons 15 are used to connect the plurality of solar cells 10 in serial, in parallel, or in serial and parallel to each other. The plurality of solar cells 10 that are electrically connected by using the ribbons 15 constitute solar cell strings 17 that are disposed adjacent to each other in several rows.

The ribbons 15 may be used to connect the front surface electrode formed on the light receiving surface of the solar cells 10 and the rear surface electrode formed on the other surface of the solar cells 10 through tabbing. Tabbing may be performed by coating a flux on one surface of the solar cells 10, placing the ribbons 15 on the solar cells 10 coated with the flux, and carrying out sintering.

Alternatively, the solar cells 10 may be connected in serial, in parallel, or in serial and parallel to each other by thermal compression after attaching a conductive film (not shown) between one surface of the solar cells 10 and the ribbons 15. The conductive film (not shown) is a film formed of an epoxy resin, an acrylic resin, a polyimide resin, a polycarbonate resin, etc. in which conductive particles formed of gold, silver, nickel, copper, etc. having excellent conductivity are scattered. The conductive particles come out of the film by thermal compression so that the solar cells 10 and the ribbons 15 are electrically connected to each other. As such, when the plurality of solar cells are connected to each other by using the conductive film (not shown), a processing temperature is lowered, which prevents the solar cell string 17 from being bent.

Bus ribbons (or conductor) 18 are used to alternately connect both ends of the ribbons 15 of the solar cell string 17. A pair of the bus ribbons 18 having different polarities penetrate into the second substrate 12 so that the bus ribbon 18 protrudes outside. The bus ribbons 18 are connected to the junction box 20 disposed on a rear surface of the photovoltaic module 1.

The junction box 20 collects electricity generated by the plurality of solar cells 10, prevents a current from flowing backward, and controls the current to flow forward. According to the embodiment of the present invention, the junction box 20 is attached to the photovoltaic module 1 in one-touch type so that the junction box 20 is electrically connected to the bus ribbons 18.

As shown in FIG. 2A, end portions 18a of the bus ribbons 18 extend by penetrating into a rear surface of the photovoltaic module 1 that is an opposite surface of the light receiving surface, for example, through holes h formed in the second substrate 12. Thereafter, an extension portion 110 of the junction box 20 is attached to the rear surface of the photovoltaic module 1. Concurrently, the end portions 18a of the bus ribbons 18 contact conductive connection members 200 formed inside the junction box 20 and thus are electrically connected to the junction box 20.

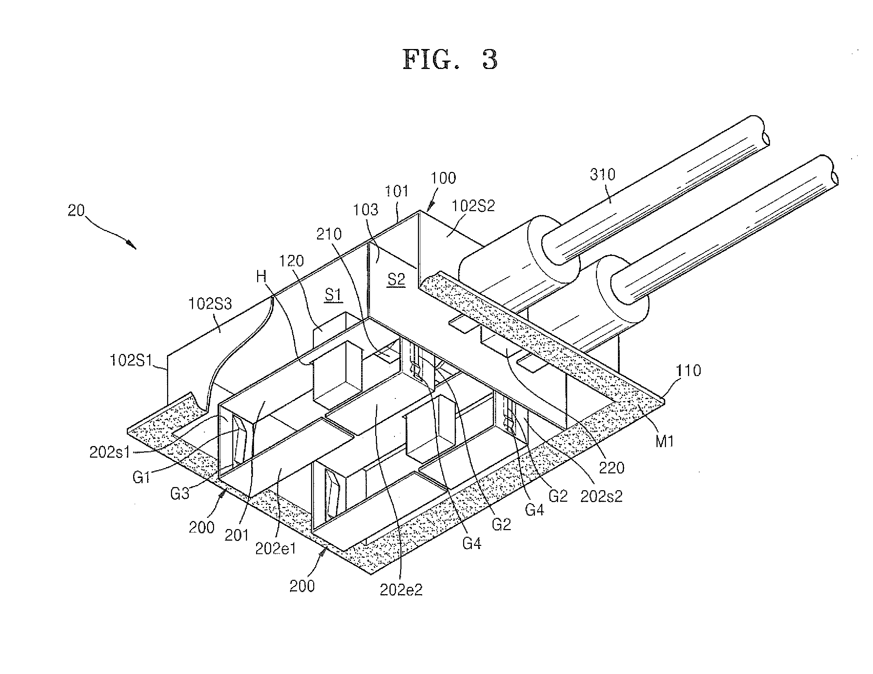

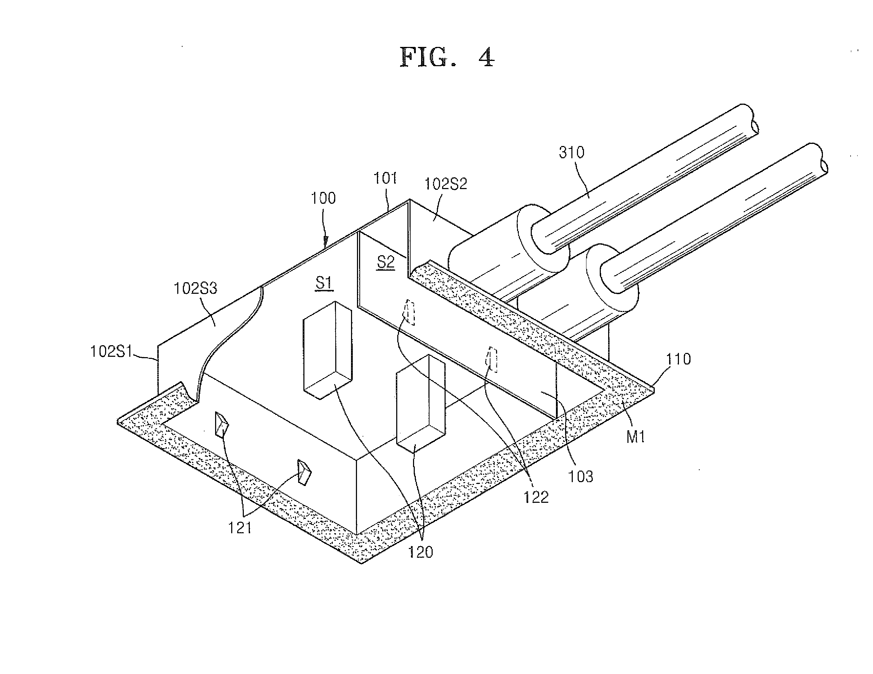

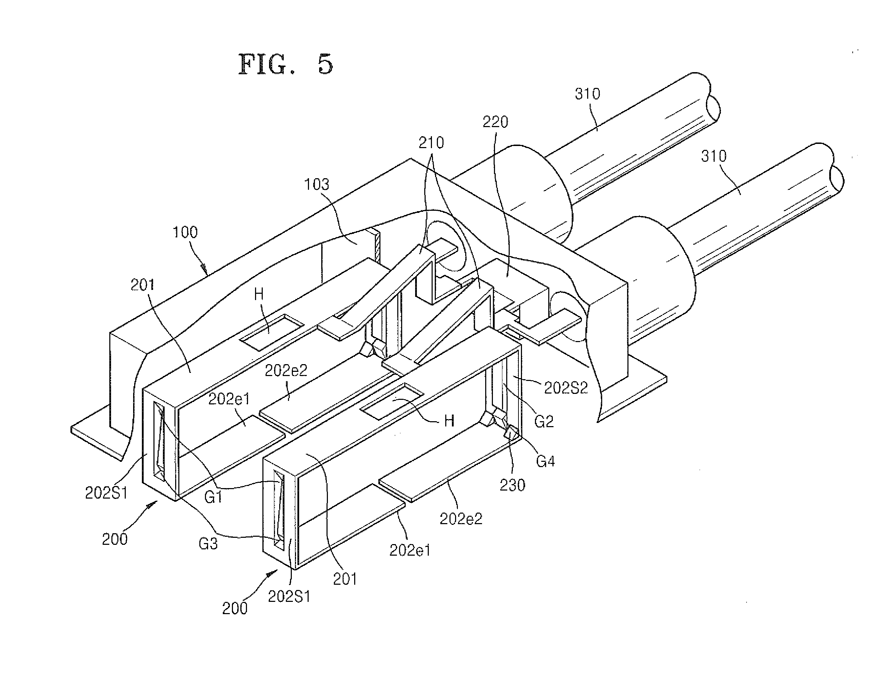

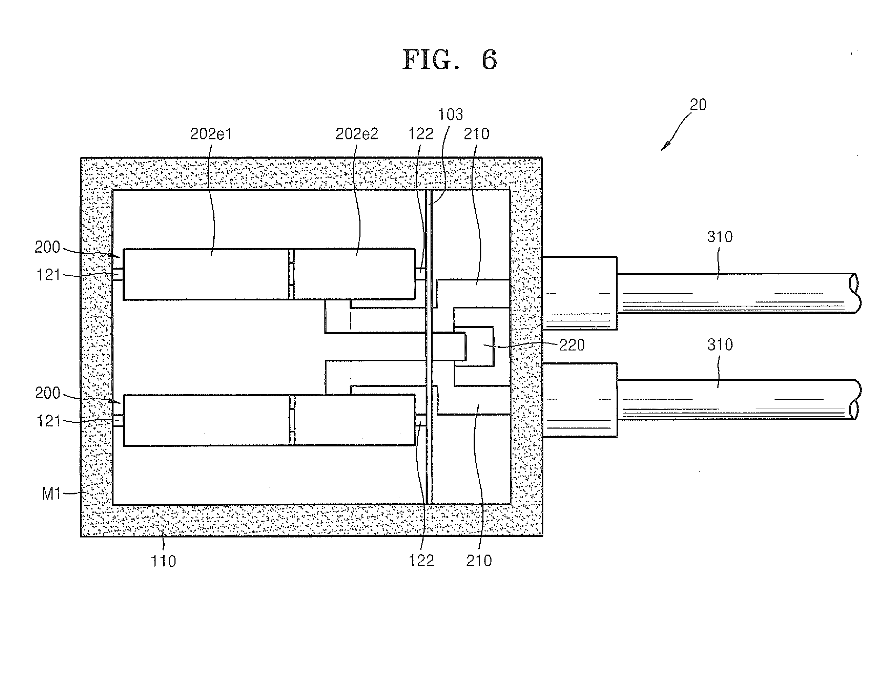

FIG. 3 is a bottom perspective view of the junction box 20 according to an embodiment of the present invention. FIG. 4 is a bottom perspective view of a housing 100 of the junction box 20. FIG. 5 is a top perspective view of the conductive connection members 200 of the junction box 20. FIG. 6 is a bottom view of the junction box 20 of FIG. 3. For convenience of explanation, a part of one side surface 102S3 of the housing 100 is opened in FIG. 3.

Referring to FIG. 3, the junction box 20 according an embodiment of the present invention includes the housing 100, the conductive connection members 200 disposed inside the housing 100, a diode 220, and a cable 310 extending outside of the housing 100. As shown in FIG. 2A, the pair of bus ribbons 18 penetrate into the second substrate 12 and protrude outside, and thus a pair of conductive connection members 200 are provided. A structure and a construction of each of the conductive connection members 200 is the same.

Referring to FIGS. 3 and 4, the housing 100 has an approximately hexahedral shape having an open one surface. The housing 100 includes the extension portion 110 disposed on the same plane as the open one surface and approximately perpendicular to a side surface. For example, the housing 100 includes an upper surface 101, four side surfaces 102S1, 102S2, and 102S3, (the other side surface is not shown) approximately perpendicular to the upper surface 101, and an open lower surface facing the upper surface 101. The end portions 18a of the bus ribbons 18 are electrically connected to the conductive connection members 200 through the open lower surface. The extension portion 110 extends approximately perpendicular to the four side surfaces 102S1, 102S2, and 102S3, and is disposed to surround the open lower surface on the same plane as the open lower surface.

The housing 100 is attached to the second substrate 12 through the extension portion 110. In this regard, the lower surface of the extension portion 110 is onto the second substrate 12. A first adhesion material M1 is disposed on the lower surface of the extension portion 110. The first adhesion material M1 may use a viscosity gel adhesive or a solid adhesive tape but is not limited thereto.

An inner space of the housing 100 is divided by a barrier rib 103. As shown in FIG. 4, pressure projections 120 extending downward from the upper surface 101 of the housing 100, and first and second projections 121 and 122 respectively formed in the side surfaces 102S1 and 102S2 facing each other are disposed in a first space S1 of the housing 100 formed in one side of the barrier rib 101. A diode 220 electrically connected to the conductive connection member 200 is disposed in a second space S2 of the housing 100.

The pressure projections 120 extend downward through holes H formed in the upper surface 201 of the conductive connection member 200. The first and second projections 121 and 122 are respectively formed in the side surfaces 102S1 and 102S2 facing each other to hold the conductive connection member 200 so that the conductive connection member 200 does not fall down before the junction box 20 is attached onto the second substrate 12. Furthermore, the first projections 121 function to push one side of the conductive connection member 200 so that the bus ribbons 18 and the conductive connection member 200 contact each other when the junction box 20 is attached onto the second substrate 12.

Referring to FIGS. 3 and 5, the conductive connection member 200 electrically connects the end portions 18a of the bus ribbons 18 described with reference to FIGS. 2A and 2B and the cable 310 extending outside of the housing 100. Before the junction box 20 is attached onto the second substrate 12, the conductive connection member 200 is partially accommodated in the housing 100. After the junction box 20 is attached onto the second substrate 12, the conductive connection member 200 is wholly accommodated in the housing 100, and the end portions 18a of the bus ribbons 18 and the conductive connection member 200 are electrically connected.

The conductive connection member 200 includes the upper surface 201 through which the pressure projections 120 pass, a first side surface 202S1 and a second side surface 202S2 approximately perpendicular to the upper surface 201 and facing each other, a first end portion 202e1 extending approximately perpendicular to the first side surface 202S1, and a second end portion 202e2 extending approximately perpendicular to the second side surface 202S2, and lead plates 210 for connecting the conductive connection member 200 and the cable 310.

The first end portion 202e1 and the second end portion 202e2 are disposed on the same plane and spaced apart from each other by a gap therebetween. The end portions 18a of the bus ribbons 18 extend through the gap between the first end portion 202e1 and the second end portion 202e2, overlap each other between the first end portion 202e1 and the second end portion 202e2, and are electrically connected to the conductive connection member 200. The lead plates 210 pass through the barrier rib 103 of the housing 100 so as to extend toward the second space S2, and are connected to the cable 310.

The first side surface 202S1 of the conductive connection member 200 is disposed to face the side surface 102S1 of the housing 100 in which the first projections 121 are formed. The second side surface 202S2 of the conductive connection member 200 is disposed to face the other side surface 102S2 of the housing 100 in which the second projections 122 are formed.

The first side surface 202S1 of the conductive connection member 200 includes a first guide groove G1 and a first coupling groove G3 disposed below the first guide groove G1. The second side surface 202S2 of the conductive connection member 200 includes a second guide groove G2 and a second coupling groove G4 disposed below the second guide groove G2. Before the junction box 20 is attached onto the second substrate 12, at least a part of the and second projections 121 and 122 are accommodated in the first guide groove G1 and the second guide groove G2 respectively, and the conductive connection member 200 is partially accommodated in the housing 100.

When the junction box 20 is attached onto the second substrate 12, the conductive connection member 200 is partially accommodated in the housing 100 relatively moves toward the upper surface 101 of the housing 100 so that the conductive connection member 200 may be wholly accommodated in the housing 100. In this regard, the first projections 121 of the housing 100 move along the first guide groove G1 and are accommodated in the first coupling groove G3, and the second projections 122 of the housing 100 move along the second guide groove G2 and are accommodated in the second coupling groove G4.

A depth of the first guide groove G1 and a depth of the first coupling groove G3 are different from depths of the first projections 121. In particular, the depth of the first guide groove G1 and the depth of the first coupling groove G3 are lower than the projection-heights of the first projections 121. The first guide groove G1 has an inclination such that the depth of the first guide groove G1 reduces downward. Thus, as the conductive connection member 200 moves into the housing 100, the first projections 121 move the first end portion 202e1 toward the second end portion 202e2. When the first projections 121 are accommodated in the first coupling groove G3 through the first guide groove G1, the first side surface 202S1 is pushed toward the second side surface 202S2 by the first projections 121, and the first end portion 202e1 connected to the first side surface 202S1 moves toward the second end portion 202e2. In this regard, the end portions 18a of the bus ribbons 19 extending perpendicular to the gap between the first end portion 202e1 and the second end portion 202e2 are bent to overlap each other between the first end portion 202e1 and the second end portion 202e2.

As described above, when the conductive connection member 200 moves into the housing 100, although the first end portion 202e1 is caused to move toward the second end portion 202e2 by the first projections 121, the second end portion 202e2 does not move toward the first end portion 202e1 although the conductive connection member 200 moves upward. That is, the second side surface 202S2 and the second end portion 202e2 of the conductive connection member 200 remain perpendicular to each other.

To this end, the second guide groove G2 and the second coupling groove G4 are formed such that the second projections 122 do not push the second side surface 202S2 or move the second end portion 202e2 although the conductive connection member 200 moves upward. A depth of the second guide groove G2 and a depth of the second coupling groove G4 are substantially the same as projection-heights of the second projections 122, and the second guide groove G2 is parallel to the second side surface 202S2 unlike the first guide groove G1.

The conductive connection member 200 further include an angle maintaining member 230 for maintaining an angle between the second side surface 202S2 and the second end portion 202e2. If a force other than an external force of the second projections 122 for attaching the junction box 20 is applied, the angle between the second side surface 202S2 and the second end portion 202e2 has a uniform value.

As shown in FIGS. 5 and 6, the lead plates 210 extend from the upper surface 201 of the conductive connection member 200 to the cable 310. The lead plates 210 pass through the barrier rib 103 disposed between the first and second spaces S1 and S2. One side of the lead plates 210 in the first space S1, which is coupled to the upper surface 201 of the conductive connection member 200, includes a connection portion bent to have a predetermined angle as shown in FIG. 5. The connection portion of the lead plates 210 may be elastic. Thus, when the junction box 20 is attached onto the second substrate 12, and the conductive connection member 200 relatively moves upward, the connection portion of the lead plates 210 becomes flat and contacts an inner side of the upper surface 101 of the housing 100.

The diode 220 may be disposed in the second space S2 of the housing 100 and is electrically connected to the conductive connection member 200. For example, the diode 220 may be electrically connected to the lead plates 210 extending in the second space S2. The diode 220 prevents a current through in the cable 310 from flowing backward, and controls the current to flow forward.

An attachment of the junction box 20 and an electrical connection of the bus ribbons 18 and the junction box 20 will now be described below.

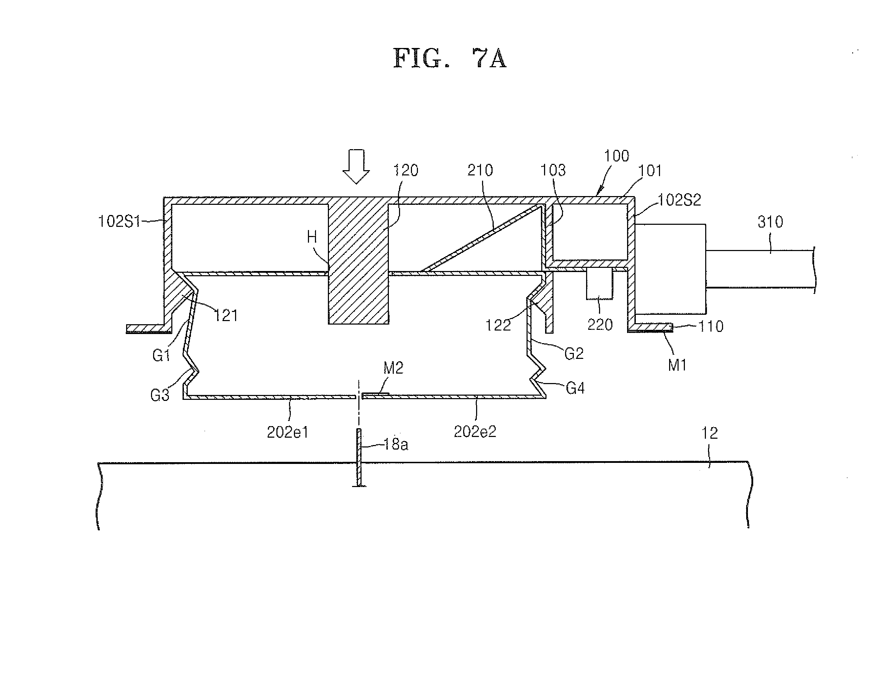

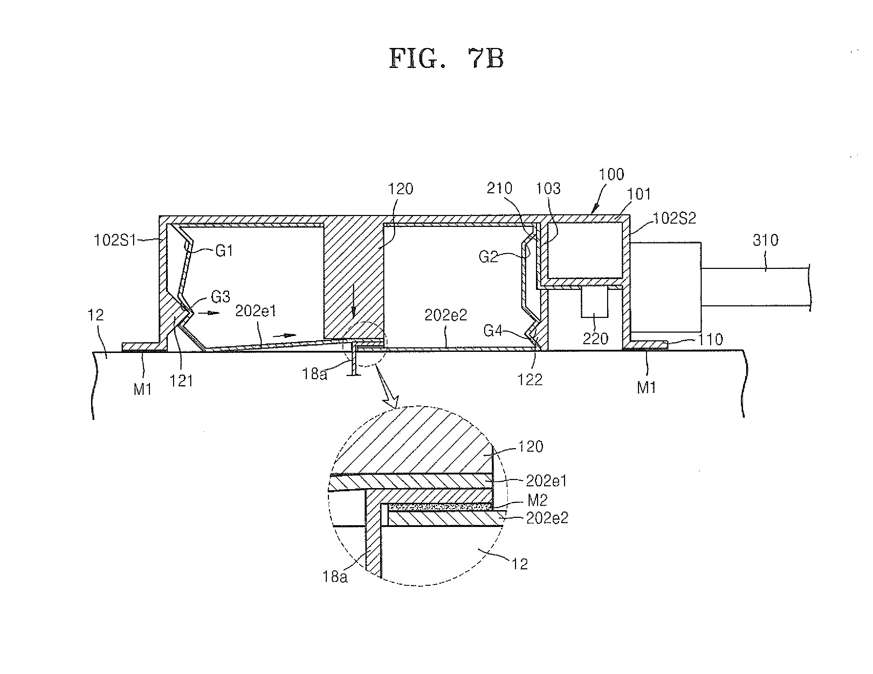

FIG. 7A is a lateral cross-sectional view of the junction box 20 before attachment to the second substrate 12. FIG. 7B is a lateral cross-sectional view of the junction box 20 after attachment to the second substrate 12.

Referring to FIG. 7A, the pressure projections 120 extend downward through the holds H formed in the upper surface 201 of the conductive connection member 200. A gap between the first end portion 202e1 and the second end portion 202e2 of the conductive connection member 200 is disposed below the pressure projections 120, and the end portions 18a of the bus ribbons 18 protrude through the gap. That is, the pressure projections 120 are disposed at a location corresponding to the gap, for example, above the gap.

At least a part of the first projections 121 formed in the first side surface 202S1 of the housing 100 is accommodated in the first guide groove G1, and at least a part of the second projections 122 formed in the second side surface 202S2 is accommodated in the second guide grove G2, so that the conductive connection member 200 is partially accommodated in the housing 100 and held by the first and second projections 121 and 122 disposed both sides thereof.

As described above, the lead plates 210 extend through the barrier rib 103 to connect the upper surface 201 of the conductive connection member 200 and the cable 310. One side of the lead plates 210 adjacent to the upper surface 201 of the conductive connection member 200 includes a connection portion, and another side of the lead plates 210 adjacent to the cable 310 is connected to the cable 310 through the barrier rib 103.

The first adhesion material M1 is disposed on one side surface of the extension portion 110 of the housing 100, i.e., a surface facing an upper surface of the second substrate 12.

A second adhesion material M2 is disposed on the second end portion 202e2. The second adhesion material M2 disposed on the second end portion 202e2 is a conductive adhesion material for providing an electric connection between the end portions 18a of the bus ribbons 18 and the conductive connection member 200.

Referring to FIG. 7B, when the junction box 20 is provided on the second substrate 12, one side surface of the extension portion 110, i.e. a lower surface, contacts the second substrate 12, and the junction box 20 is attached onto the second substrate 12 by using the first adhesion material M1 disposed between the extension portion 110 and the second substrate 12. Concurrently with the attachment of the junction box 20 onto the second substrate 12, the end portions 18a of the bus ribbons 18 disposed on the gap are bent to overlap each other between the first end portion 202e1 and the second end portion 202e2 and are electrically connected to the conductive connection member 200.

A process of electrically connecting the bus ribbons 18 and the conductive connection member 200 is as follows.

When the junction box 20 is attached onto the second substrate 12, the conductive connection member 200 disposed between the second substrate 12 and the housing 100 relatively moves into the housing 100. In this regard, the first projections 121 formed in one side surface of the housing 100 are accommodated in the first coupling groove G3 through the first guide groove G1, and the second projections 122 formed in another side surface of the housing 100 are accommodated in the second coupling groove G4 through the second guide groove G2.

A depth of the second guide groove G2 and a depth of the second coupling groove G4 are substantially the same as projection-heights of the second projections 122 and thus the second side surface 202S2 of the conductive connection member 200 and the second end portion 202e2 extending approximately perpendicular to the second side surface 202S2 are intactly accommodated in the housing 100.

However, a depth of the first guide groove G1 and a depth of the first coupling groove G3 are lower than projection-heights of the first projections 121, and the depth of the first guide groove G1 is reduced downward such that the first guide groove G1 has an inclination, and thus according to the relative movement of the conductive connection member 200, the first side surface 202S1 is pushed toward the second side surface 202S2, and the first end portion 202e1 connected to the first side surface 202S1 moves toward the second end portion 202e2.

The end portions 18a of the bus ribbons 18 are bent to contact the second end portion 202e2 by the first end portion 202e1 that moves toward the second end portion 202e2, pushed by the first projections 121. In this regard, the pressure projections 120 press an overlapping region of the first end portion 202e1 and the second end portion 202e2, such that the end portions 18a of the bus ribbons 18 contact the first end portion 202e1 and the second end portion 202e2 while being disposed between the second end portion 202e2 and the first end portion 202e1. The end portions 18a of the bus ribbons 18 may be more clearly adhered and electrically connected to the second end portion 202e2 through the second adhesion material M2 disposed on the second end portion 202e2.

As described above, the junction box 20 can be electrically connected to the bus ribbons 18 concurrently with the attachment of the junction box 20 onto the second substrate 12 in a single action, thereby advantageously carrying out an electrical connection stably and achieving excellent assembling.

It should be understood that the exemplary embodiments described therein should be considered in a descriptive sense only and not for purposes of limitation. Descriptions of features or aspects within each embodiment should typically be considered as available for other similar features or aspects in other embodiments.

## Claims

1. A junction box comprising:
a housing (100);
a conductive connection member (200) formed from a resilient conductive material and having first and second end portions (202e1, 202e2);
wherein the conductive connection member is moveable between a first position disposed at least partially outside the housing and a second position disposed substantially entirely within the housing;
wherein one of the conductive connection member or the housing comprises a first groove and the other of the conductive connection member or the housing comprises a first projection (121), wherein the first groove comprises an inclined surface such that as the conductive connection member moves between the first position and the second position the first projection moves in the first groove and the conductive connection member is compressed such that at least one of the first and second end portions is moved towards the other.

2. A junction box according to claim 1, wherein, in the first position, the first and second end portions are spaced apart from each other.

3. A junction box according to claim 1 or 2, wherein, in the second position, the first and second end portions overlap.

4. A junction box according to claim 3, wherein the housing comprises a pressure projection (120) which is configured to contact an overlapping portion of one of the first and second end portions in the second position.

5. A junction box according to claim 3 or 4, wherein one of the first and second end portions includes an adhesive material (M2), preferably a conductive adhesive material, on a portion which is overlapped in the second position.

6. A junction box according to any one of the preceding claims, wherein the first groove comprises a first guide groove (G1) including the inclined surface and a first coupling groove (G4) in which the first projection (121) engages in the second position.

7. A junction box according to any one of the preceding claims, wherein the housing comprises an extension portion (110) projecting from the housing and comprising an attachment surface which is in the same plane as a bottom surface of the conductive connection member in the second position.

8. A junction box according to claim 7, having an adhesive material (M1) on the attachment surface.

9. A junction box according to any one of the preceding claims, wherein one of the conductive connection member or the housing comprises a second groove and the other of the conductive connection member or the housing comprises a second projection which moves in the second groove as the conductive connection member moves between the first position and the second position.

10. A junction box according to claim 9, wherein the second groove comprises a second guide groove (G2) having a surface parallel to the direction of movement of the conductive connection member and a second coupling groove (G3) in which the second projection engages in the second position.

11. A junction box according to claim 9 or 10, wherein the first groove and the first end portion are disposed on a first side of the conductive connection member, and the second groove and the second end portion are disposed on a second side of the conductive connection member opposite the first side wherein, as the conductive connection member moves between the first position and the second position, the first end portion moves towards the second end portion but the second end portion does not move towards the first end portion.

12. A junction box according to any one of the preceding claims, wherein the conductive connection member comprises an angle maintaining member (230) configured to maintain an angle of the second end portion with respect to the direction of movement of the conductive connection member.

13. A junction box according to any one of the preceding claims, comprising a lead plate formed from a conductive resilient material and configured to connect the conductive connection member to a cable, the lead plate comprising a connection portion connected to a top portion of the conductive connection member.

14. A junction box according to any one of the preceding claims, wherein the first groove or the first and second grooves are formed in the conductive connection member, and the first projection or the first and second projections are on the housing.

15. A photovoltaic module including a plurality of photovoltaic cells (10) on a front surface of a substrate (12); at least one conductor connected to the photovoltaic cells and passing through the substrate and projecting from a rear surface of the substrate; and a junction box according to any one of the preceding claims, wherein the conductor is gripped between the first and second end portions in the second position.

16. A method of attaching a junction box to a conductor projecting from a surface comprising:
providing a junction box comprising:
a housing (100);
a conductive connection member (200) positioned partially inside the housing and formed from a resilient conductive material and having first and second end portions (202e1, 202e2) spaced apart from each other;
positioning the junction box with the conductor between the first and second end portions;
moving the housing such that the conductive connection member moves entirely inside the housing and the housing contacts the surface;
wherein one of the conductive connection member or the housing comprises a first groove and the other of the conductive connection member or the housing comprises a first projection (121), wherein the first groove comprises an inclined surface such that as the conductive connection member moves into the housing the first projection moves in the first groove and the conductive connection member is compressed such that at least one of the first and second end portions is moved towards the other to grip the conductor.

17. A method according to claim 16, wherein when the conductive connection member is entirely within the housing, the first and second end portions overlap, and the flexible conductor is gripped between the overlapping portions.
